# EUROPEAN PATENT APPLICATION

(11) **EP 4 411 820 A1**
(43) Date of publication of application: **07.08.2024**
(21) Application number: 23218544.7
(22) Date of filing: 20.12.2023
(51) Int. Cl.: H01L 27/15, H01L 33/00, H01L 33/38, H01L 33/40, H01L 33/44

(54) **SEMICONDUCTOR LIGHT EMITTING DEVICE**

(30) Priority: 03.02.2023 KR 20230014899
(71) Applicant: Samsung Electronics Co., Ltd., Suwon-si, Gyeonggi-do 16677 (KR)
(72) Inventor: KIM, Taehun, 16677 Suwon-si, Gyeonggi-do (KR); PARK, Gyeongseon, 16677 Suwon-si, Gyeonggi-do (KR); YOO, Hanul, 16677 Suwon-si, Gyeonggi-do (KR); LEE, Suyeol, 16677 Suwon-si, Gyeonggi-do (KR); JANG, Taesung, 16677 Suwon-si, Gyeonggi-do (KR); JEONG, Dooho, 16677 Suwon-si, Gyeonggi-do (KR)
(74) Representative: Kuhnen & Wacker Patent- und Rechtsanwaltsbüro PartG mbB

(57) **Abstract**

A semiconductor light emitting device includes a first conductivity type semiconductor layer, a second conductivity type semiconductor layer arranged on the first conductivity type semiconductor layer, an active layer between the first conductivity type semiconductor layer and the second conductivity type semiconductor layer, an electrode layer formed on a top surface of the second conductivity type semiconductor layer, a reflective layer formed on a part of a top surface of the electrode layer, a bonding pad formed on a top surface of the reflective layer, an insulating layer formed on another part of the top surface of the electrode layer, and an insulating spacer conformally formed along side walls of the first conductivity type semiconductor layer, the second conductivity type semiconductor layer, and the active layer, and covering a part of the side wall of the insulating layer . The reflective layer includes a material that is not etched by an aqueous solution including one of tetramethyl ammonium hydroxide (TMAH), KOH, NaOH, and NH₄OH and the bonding pad has a shell shape including a part of which the width gradually decreases as the part distances from the reflective layer.

## Description

### BACKGROUND

### 1. Field

Embodiments relate to a semiconductor light emitting device, and more particularly, to a semiconductor light emitting device with a reduced size.

### 2. Description of the Related Art

Semiconductor light emitting devices are used as light sources for various electronic products. As uses of semiconductor light emitting devices diversify, it is necessary to develop a new structure to improve optical characteristics and reliability of light source modules including semiconductor light emitting devices.

### SUMMARY

Embodiments of the invention are defined in the appended claims. Embodiments are directed to a semiconductor light emitting device capable of improving optical characteristics and productivity.

Furthermore, the technical challenges are not limited to the technical challenges mentioned above, and other technical challenges not mentioned will be clearly understood by those skilled in the art from the description below.

According to an aspect, there is provided a semiconductor light emitting device including a first conductivity type semiconductor layer arranged on a substrate, a second conductivity type semiconductor layer arranged on the first conductivity type semiconductor layer, an active layer between the first conductivity type semiconductor layer and the second conductivity type semiconductor layer, an electrode layer formed on a top surface of the second conductivity type semiconductor layer, a reflective layer formed on a part of a top surface of the electrode layer, a bonding pad formed on a top surface of the reflective layer, an insulating layer formed on another part of the top surface of the electrode layer, and an insulating spacer conformally formed along a surface of the substrate, surrounding side walls of the first conductivity type semiconductor layer, the second conductivity type semiconductor layer, and the active layer, and covering a part of the side wall of the insulating layer. The reflective layer includes a material that is not etched by an aqueous solution including one of tetramethyl ammonium hydroxide (TMAH), KOH, NaOH, and NH₄OH and the bonding pad has a shell shape including a part of which the width gradually decreases as the part distances from the reflective layer.

According to another aspect, there is provided a semiconductor light emitting device including a plurality of first conductivity type semiconductor layers arranged on a substrate, a plurality of second conductivity type semiconductor layers formed on the plurality of first conductivity type semiconductor layers, a plurality of active layers between the plurality of first conductivity type semiconductor layers and the plurality of second conductivity type semiconductor layers, a plurality of electrode layers formed on top surfaces of the plurality of second conductivity type semiconductor layers, a plurality of reflective layers formed on parts of top surfaces of the plurality of electrode layers, a plurality of bonding pads formed on top surfaces of the plurality of reflective layers, an insulating layer formed on other parts of the top surfaces of the plurality of electrode layers, an insulating spacer conformally formed along a surface of the substrate, surrounding side walls of the plurality of first conductivity type semiconductor layers, the plurality of second conductivity type semiconductor layers, and the plurality of active layers, and covering a part of a side wall of the insulating layer, and an oxide layer contacting a side wall of each of the plurality of reflective layers. The oxide layer does not horizontally overlap the insulating spacer. The plurality of reflective layers include a material that is not etched by an aqueous solution including one of tetramethyl ammonium hydroxide (TMAH), KOH, NaOH, and NH₄OH. The plurality of reflective layers include one of chrome (Cr), nickel (Ni), and a noble metal material. Each of the plurality of bonding pads has a shell shape including a part of which the width gradually decreases as the part distances from each of the plurality of reflective layers.

According to another aspect of the inventive concept, there is provided a semiconductor light emitting device including an n-type gallium nitride (GaN) layer, a p-type GaN layer including a plurality of protrusions apart from one another on the n-type GaN layer, a plurality of p-electrode layers formed on top surfaces of the plurality of protrusions, a plurality of reflective layers formed on parts of top surfaces of the plurality of p-electrode layers, a plurality of oxide layers formed on side walls of the plurality of reflective layers, a plurality of bonding pads formed on top surfaces of the plurality of reflective layers, an insulating layer formed on other parts of the top surfaces of the plurality of p-electrode layers, an insulating spacer conformally formed along a surface of the p-type GaN layer among the plurality of protrusions, surrounding side walls of the plurality of p-electrode layers, and covering side walls of the plurality of p-type GaN layers, and an n-electrode layer contacting an upper portion of the n-type GaN layer. The plurality of reflective layers include one of chrome (Cr), nickel (Ni), gold (Au), platinum (Pt), palladium (Pd), and silver (Ag) and the plurality of reflective layers include a material that is not etched by an aqueous solution including one of tetramethyl ammonium hydroxide (TMAH), KOH, NaOH, and NH₄OH, and corners of top surfaces of the plurality of bonding pads are round.

### BRIEF DESCRIPTION OF THE DRAWINGS

Features will become apparent to those of skill in the art by describing in detail exemplary embodiments with reference to the attached drawings in which:
FIG. 1 is a plan view illustrating a semiconductor light emitting device according to embodiments;
FIG. 2 is a cross-sectional view illustrating examples of configurations of some components taken along the line A-A' of FIG. 1;
FIG. 3 is an enlarged cross-sectional view of a partial region indicated by "AX" in FIG. 2;
FIG. 4 is a flowchart illustrating a method of manufacturing a semiconductor light emitting device, according to embodiments;
FIGS. 5A to 5D are cross-sectional views illustrating a method of manufacturing a semiconductor light emitting device, according to embodiments in a process order;
FIGS. 6A to 6C are cross-sectional views illustrating a method of manufacturing a semiconductor light emitting device including an oxide layer employable in the semiconductor light emitting device according to another embodiment;
FIG. 7 is a cross-sectional view illustrating a semiconductor light emitting device according to another embodiment;
FIG. 8 is an enlarged cross-sectional view of a partial region indicated by "BX" in FIG. 7;
FIG. 9 is a flowchart illustrating a method of manufacturing a semiconductor light emitting device, according to another embodiment;
FIGS. 10A to 10F are cross-sectional views illustrating a method of manufacturing a semiconductor light emitting device, according to another embodiment, in a process order;
FIG. 11 is a flowchart illustrating a method of manufacturing a semiconductor light emitting device, according to another embodiment;
FIGS. 12A to 12E are cross-sectional views illustrating a method of manufacturing a semiconductor light emitting device, according to another embodiment, in a process order;
FIG. 13 is a block diagram illustrating a configuration of a light source module according to another embodiment;
FIG. 14 is a perspective view schematically illustrating a lighting device including a light source module according to embodiments;
FIG. 15 is a perspective view schematically illustrating a flat panel lighting device including a light source module according to embodiments;
FIG. 16 is an exploded perspective view schematically illustrating a lighting device including a light source module according to embodiments;
FIG. 17 is an exploded perspective view schematically illustrating a bar type lighting device including a light source module according to embodiments;
FIG. 18 is an exploded perspective view schematically illustrating a lighting device including a light source module according to embodiments;
FIG. 19 is a schematic diagram illustrating an indoor lighting control network system including a light source module according to embodiments; and
FIG. 20 is a schematic diagram illustrating a network system including a light source module according to embodiments.

### DETAILED DESCRIPTION

Hereinafter, embodiments of the inventive concept will be described in detail with reference to the accompanying drawings. Like numeral references refer to like elements, and their repetitive descriptions are omitted.

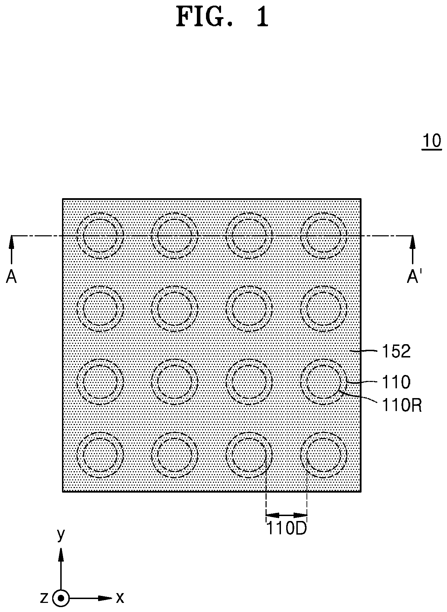

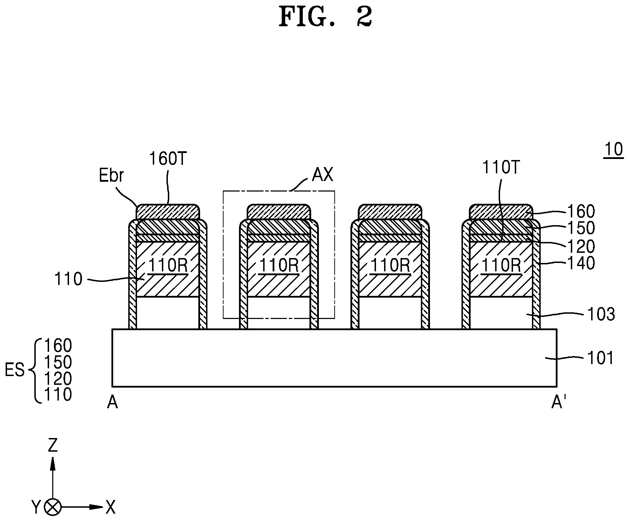

FIG. 1 is a plan view illustrating a semiconductor light emitting device 10 according to embodiments. FIG. 2 is a cross-sectional view illustrating examples of configurations of some components taken along the line A-A' of FIG. 1.

Referring to FIGS. 1 and 2, the semiconductor light emitting device 10 may include a conductivity type semiconductor layer 110, an insulating spacer 140, a plurality of electrode layers 120, a plurality of reflective layers 150, and a plurality of bonding pads 160 formed on a substrate 101. The conductivity type semiconductor layer 110 may include a first conductivity type semiconductor layer 110n, a second conductivity type semiconductor layer 1 10p, and an active layer 110a. Here, a light emitting structure ES may include the conductivity type semiconductor layer 110, the electrode layer 120, the reflective layer 150, and the bonding pad 160.

The substrate 101 may be arranged under the light emitting structure ES to support the light emitting structure ES. The substrate 101 may receive heat generated by the light emitting structure ES through a base layer 103 and may emit the received heat to the outside. In addition, the substrate 101 may have light transmittance. A light transmitting material or a material capable of transmitting light when formed to a certain thickness or less may be used as the substrate 101.

The substrate 101 may include an insulating, conductive, or semiconductor substrate as needed. For example, the substrate 101 may include sapphire (Al₂O₃), gallium nitride (GaN), silicon (Si), germanium (Ge), gallium arsenide (GaAs), zinc oxide (ZnO), silicon germanium (SiGe), silicon carbide (SiC), gallium oxide (Ga₂O₃), lithium gallium oxide (LiGaO₂), lithium aluminum oxide (LiAlO₂), or magnesium aluminum oxide (MgAl₂O₄).

In some embodiments, an Al₂O₃ substrate, an SiC substrate, or an Si substrate is mainly used as the substrate 101. The Al₂O₃ substrate that is less expensive than the SiC substrate is used more.

The substrate 101 may be completely or partially removed in manufacturing processes of the semiconductor light emitting device 10 to improve optical characteristics or electrical characteristics before or after formation of the light emitting structure ES. The Al₂O₃ substrate may be removed by irradiating a laser to an interface with the base layer 103 therethrough, and the Si substrate and the SiC substrate may be removed by polishing or etching.

The base layer 103 may be formed to provide a growth surface for the light emitting structure ES. For example, the base layer 103 may include InₓAl_{y}Ga_{(1-x-y)} (0≤x
≤ 1 and 0≤y≤1), GaN, aluminum nitride (AlN), aluminum gallium nitride (AlGaN), indium gallium nitride (InGaN), or InGaNAlN and may also include a material such as ZrB₂, HfB₂, ZrN, HfN, or TiN if necessary. In addition, the base layer 103 may include an undoped GaN layer. In some configurations, the base layer 103 may be formed in a multilayer structure or used by gradually changing a composition. In other embodiments, the base layer 103 may be omitted.

The first conductivity type semiconductor layer 110n may include a nitride semiconductor having a composition of n-type InₓAl_{y}Ga_{(1-x-y)}N (0≤x<1, 0≤y<1, and 0≤x+y<1). For example, an n-type impurity may include Si. Alternatively, the first conductivity type semiconductor layer 110n may include GaN including an n-type impurity. The first conductivity type semiconductor layer 110n may form a flat surface contacting a bottom surface of the second conductivity type semiconductor layer 110p. The first conductivity type semiconductor layer 110n may be referred to as an n-type GaN layer.

In embodiments, the first conductivity type semiconductor layer 110n may include a first conductivity type semiconductor contact layer and a current diffusion layer. An impurity concentration of the first conductivity type semiconductor contact layer may be in a range of about 2×10¹⁸ cm⁻³ to about 9×10¹⁹ cm⁻³. A thickness of the first conductivity type semiconductor contact layer may be in a range of about 0.1 *µ*m to about 5 *µ*m. The current diffusion layer may have a structure in which a plurality of InₓAl_{y}Ga_{(1-x-y)}N layers (0≤x, y≤1, and 0≤x+y≤1) having different compositions or different impurity contents are alternately stacked. For example, the current diffusion layer may have an n-type superlattice structure in which an n-type GaN layer and/or an AlₓIn_{y}Ga_{z}N layer (0≤x≤1, 0≤y≤1, 0≤z≤1, and x+y+z≠0) each having a thickness in a range of about 1 nm to about 500 nm are alternately stacked. An impurity concentration of the current diffusion layer may be in a range of about 2× 10¹⁸ cm⁻³ to about 9×10¹⁹ cm⁻³.

The active layer 110a may be arranged between the first conductivity type semiconductor layer 110n and the second conductivity type semiconductor layer 110p. The active layer 110a may emit light having a predetermined energy by recombination of electrons and holes. The active layer 110a may have a multi-quantum well (MQW) structure in which a quantum well layer and a quantum barrier layer are alternately stacked. In embodiments, the quantum well layer and the quantum barrier layer may include InₓAl_{y}Ga_{(1-x-y)}N layers (0≤x, y≤1, and 0≤x+y≤1) having different compositions. For example, the quantum well layer may include an InₓGa₁₋ₓN (0≤x≤1) layer, and the quantum barrier layer may include a GaN layer or an AlGaN layer. Each of the quantum well layer and the quantum barrier layer may have a thickness in a range of about 1 nm to about 50 nm. The active layer 110a may have a single quantum well structure without being limited to the MQW structure.

The second conductivity type semiconductor layer 110p may include a plurality of light emitting structures 110R. The plurality of light emitting structures 110R of the second conductivity type semiconductor layer 110p may be stacked on the first conductivity type semiconductor layer 110n. The plurality of light emitting structures 110R of the second conductivity type semiconductor layer 110p may form a mesa structure. The second conductivity type semiconductor layer 110p may be supported by the first conductivity type semiconductor layer 110n. The plurality of light emitting structures 110R of the second conductivity type semiconductor layer 110p may be apart from one another in the horizontal direction. The second conductivity type semiconductor layer 110p may be arranged in a region formed by the insulating spacer 140 to be described below. The second conductivity type semiconductor layer 110p may be referred to as a p-type GaN layer.

The second conductivity type semiconductor layer 110p may include a nitride semiconductor layer having a composition of p-type InₓAl_{y}Ga_{(1-x-y)}N (0≤x<1, 0≤y<1, and 0≤x+y<1). The p-type impurity included in the second conductivity type semiconductor layer 110p may include magnesium (Mg). In embodiments, the second conductivity type semiconductor layer 110p may include an electron blocking layer (EBL), a low-concentration p-type GaN layer, and a high-concentration p-type GaN layer serving as a contact layer. For example, the EBL may have a structure in which a plurality of InₓAl_{y}Ga_{(1-x-y)}N layers (0≤x, y≤1, and 0≤x+y≤1) each having a thickness in a range of about 5 nm to about 100 nm and having different compositions or different impurity contents are alternately stacked, or a single layer structure including Al_{y}Ga_{(1-y)}N (0<y≤1). An energy band gap of the EBL may decrease as a distance from the active layer 110a increases. For example, an Al composition of the EBL may decrease as the distance from the active layer 110a increases.

When the plurality of light emitting structures 110R are circular, a height of each of the plurality of light emitting structures 110R is in a range of about 100 nm to about 10 *µ*m, and a diameter of a top surface 110T of each of the plurality of light emitting structures 110R is in a range of about 1 *µ*m to about 100 *µ*m. In addition, the shortest distance 110D between two neighboring light emitting structures among the plurality of light emitting structures 110R may be in a range of about 100 nm to about 100 *µ*m.

The insulating spacer 140 may be conformally formed along a surface of the second conductivity type semiconductor layer 110p among the plurality of light emitting structures 110R. Specifically, the insulating spacer 140 may be conformally arranged to cover a top surface of the first conductivity type semiconductor layer 110n and a side surface of each of the plurality of light emitting structures 110R of the second conductivity type semiconductor layer 110p. The insulating spacer 140 may have a constant thickness along the side walls of the first conductivity type semiconductor layer, the second conductivity type semiconductor layer and the active layer, and may be arranged to contact a side wall of the reflective layer 150 to be described below, a side wall of the electrode layer 120, and a side wall of the second conductivity type semiconductor layer 110p.

In some embodiments, the insulating spacer 140 may be selected from oxides or nitrides such as SiO₂, SiN, SiOₓN_{y}, TiO₂, Si₃N₄, Al₂O₃, ZrO₂, TiN, AlN, TiAlN, TiSiN, HfO₂, HfAlO, and HfSiO. In some embodiments, the insulating spacer 140 may be formed in a stacked structure of a plurality of insulating layers. A thickness of the insulating spacer 140 may be in a range of about 10 nm to about 1 *µ*m. In some embodiments, the insulating spacer 140 may completely fill a space among the plurality of light emitting structures 110R. For example, the insulating spacer 140 may cover a top surface of the substrate 101 among the plurality of light emitting structures 110R without being limited to that illustrated in the drawing.

The insulating spacer 140 may entirely surround a side wall of each of the plurality of light emitting structures 110R and may protrude from the top surface 110T of each of the plurality of light emitting structures 110R. That is, the insulating spacer 140 may provide a predetermined empty space on the top surface 110T of each of the plurality of light emitting structures 110R. As described below, the electrode layer 120 and the reflective layer 150 may be formed in the empty space.

The electrode layer 120 may be formed on the top surface 110T of each of the plurality of light emitting structures 110R of the second conductivity type semiconductor layer 110p. The electrode layer 120 may contact the top surface 110T of each of the plurality of light emitting structures 110R and a side wall of the insulating spacer 140. In addition, the electrode layer 120 may be between the second conductivity type semiconductor layer 110p and the plurality of reflective layers 150. The electrode layer 120 may include a transparent material. For example, the electrode layer 120 may include indium-tin oxide (ITO), indium oxide (IO), tin oxide (SnO₂), zinc oxide (ZnO), or indium-zinc oxide (IZO). The electrode layer 120 may be referred to as a p-electrode layer. The electrode layer 120 may include silver (Ag), aluminum (Al), nickel (Ni), chrome (Cr), gold (Au), platinum (Pt), palladium (Pd), tin (Sn), tungsten (W), rhodium (Rh), iridium (Ir), ruthenium (Ru), Mg, zinc (Zn), titanium (Ti), copper (Cu), or a combination thereof. In addition, the electrode layer 120 may include a metal material having high reflectivity.

The plurality of reflective layers 150 may be formed on a top surface of the electrode layer 120. The plurality of reflective layers 150 may be between the electrode layer 120 and the second conductivity type semiconductor layer 110p. The plurality of reflective layers 150 may contact the side wall of the insulating spacer 140. The plurality of reflective layers 150 may reflect light emitted by the light emitting structure ES.

The plurality of bonding pads 160 may be bonded to an external substrate structure. The plurality of bonding pads 160 may include insulating bonding pads and conductive bonding pads. Each of the plurality of bonding pads 160 may bond the electrode layer 120 to an electrode layer of the external substrate structure. Each of the plurality of bonding pads 160 may include at least one of Au, Sn, SnAgCu, and Cu. The external substrate structure may include a driving circuit including a plurality of thin film transistor (TFT) cells for controlling the semiconductor light emitting device 10. The plurality of TFT cells may constitute TFT circuitry for controlling driving of a plurality of pixels. The plurality of TFT cells may be connected to the light emitting structure ES through the plurality of bonding pads 160.

The plurality of light emitting structures ES are arranged on the substrate 101, but the plurality of light emitting structures ES may be separated from the substrate 101. In addition, a first bonding layer (not shown) may be formed on a bottom surface of the light emitting structure ES. A second bonding layer (not shown) may be formed on a top surface of a conductive substrate (not shown) including a material that is different from that of the substrate 101. The conductive substrate may include a metal substrate or a high-concentration silicon substrate, and the metal substrate may include a metal such as Cu, Ni, cobalt (Co), W, molybdenum (Mo), Au, Al, Pt, Pd, Ti, tantalum (Ta), Sn, iron (Fe), Cr or an alloy thereof. Here, the first bonding layer and the second bonding layer may be bonded to one another. Accordingly, the plurality of light emitting structures ES may be bonded to the substrate 101 and other conductive substrates.

In this way, by isolating the plurality of light emitting structures ES and arranging the plurality of light emitting structures ES on different substrates, the plurality of light emitting structures ES may be arranged in units of pixels for a display and lighting. By using the light emitting structure ES according to the inventive concept having a reduced size, the number of light emitting structures ES arranged in units of pixels may be increased.

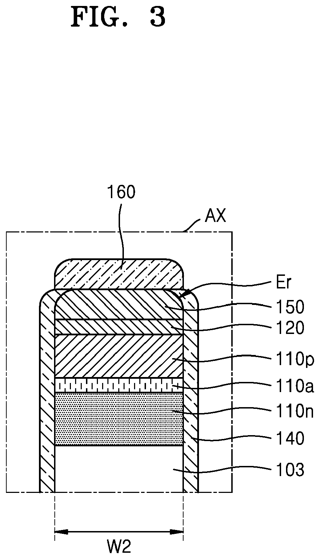

FIG. 3 is an enlarged cross-sectional view of a partial region indicated by "AX" in FIG. 2. In FIG. 3, the same reference numerals as in FIGS. 1 and 2 denote the same components and description thereof is omitted.

Referring to FIG. 3, a horizontal width of the light emitting structure 110R of the second conductivity type semiconductor layer 110p may be the same as a horizontal width of each of the electrode layer 120, the reflective layer 150, and the bonding pad 160. In embodiments, the horizontal width of each of the light emitting structure 110R, the electrode layer 120, the reflective layer 150, and the bonding pad 160 may be a second width W2. In addition, the bonding pad 160 may vertically overlap the light emitting structure 110R of the second conductivity type semiconductor layer 110p, the electrode layer 120, and the reflective layer 150.

A corner Er of the uppermost surface of each of the plurality of reflective layers 150 may have a round shape. The corner Er may be apart from each of the plurality of bonding pads 160. The insulating spacer 140 may be between the corner Er and the plurality of bonding pads 160. That is, a part of the uppermost surface of each of the plurality of reflective layers 150 may be covered with the insulating spacer 140. The lowermost surface of each of the plurality of reflective layers 150 may form a flat surface contacting the electrode layer 120.

Because the insulating spacer 140 is formed at the round corner Er, the semiconductor light emitting device 10 may provide structural stability. Although the corner Er is illustrated as being round, the inventive concept is not limited thereto. For example, the corner Er may be rectangular.

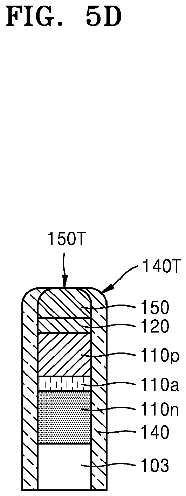

A vertical level of the uppermost surface 150T (see FIG. 5D) of each of the plurality of reflective layers 150 may be the same as a vertical level of the uppermost surface 140T (see FIG. 5D) of the insulating spacer 140. Here, the vertical level may mean a distance from the first conductivity type semiconductor layer 110n.

In addition, a corner Ebr of the uppermost surface of each of the plurality of bonding pads 160 may have a round shape. Each of the plurality of reflective layers 150 and the plurality of bonding pads 160 may have a shell shape of which the uppermost surface is round. The bonding pad may have the shell shape including a part of which the width gradually decreases as the part distances from the reflective layer. In addition, through chemical mechanical polishing (CMP) performed on the semiconductor light emitting device 10, a top surface of each of the plurality of bonding pads 160 may have an angular shape. The horizontal widths of the plurality of bonding pads 160 and the plurality of reflective layers 150 may be the same. In addition, the horizontal width of each of the plurality of reflective layers 150 and the plurality of bonding pads 160 may be the same as the horizontal width of the second conductivity type semiconductor layer 110p.

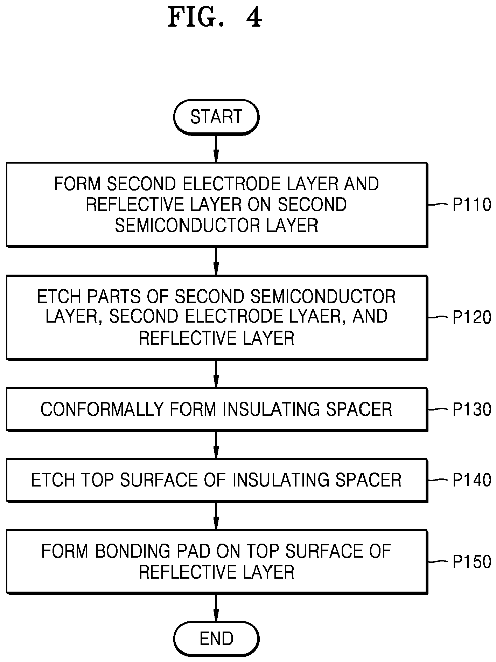

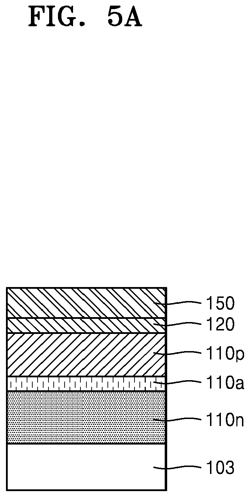

FIG. 4 is a flowchart illustrating a method of manufacturing a semiconductor light emitting device, according to embodiments. FIGS. 5A to 5D are cross-sectional views illustrating a method of manufacturing a semiconductor light emitting device, according to embodiments in a process order.

Referring to FIGS. 4 and 5A, first, the electrode layer 120 and the reflective layer 150 may be formed on the second conductivity type semiconductor layer 110p in operation P110. Before operation P110, the operation of sequentially forming the base layer 103 and the first conductivity type semiconductor layer 110n on the substrate 101 may be performed. Here, the electrode layer 120 and the reflective layer 150 may be sequentially stacked.

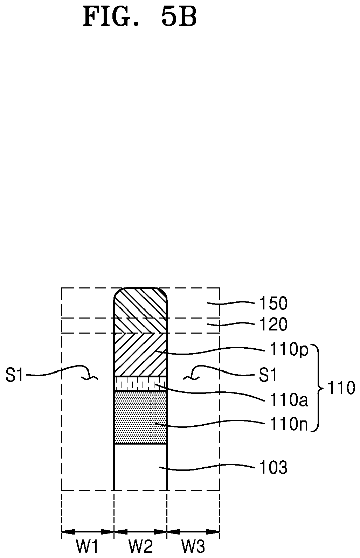

Referring to FIGS. 4 and 5B, next, parts of the second conductivity type semiconductor layer 110p, the electrode layer 120, and the reflective layer 150 are etched in operation P120. Here, a mask pattern (not shown) may be formed on the reflective layer 150, and an isolation region S1 defining the plurality of light emitting structures 110R may be formed by using the mask pattern as an etching mask. An aqueous solution including one of tetramethyl ammonium hydroxide (TMAH), KOH, NaOH, and NH₄OH may be used for an etching process of forming the isolation region S1. Here, the reflective layer 150 may include one of chrome (Cr), nickel (Ni), and a noble metal material. Here, the noble metal material may include at least one of Au, Pt, Pd, and Ag. In addition, the reflective layer 150 may include a material that is not etched by the aqueous solution including one of TMAH, KOH, NaOH, and NH₄OH. Therefore, the reflective layer 150 may not be damaged during the etching process using the aqueous solution including one of TMAH, KOH, NaOH, and NH₄OH. Here, because the reflective layer 150 includes at least one of Au, Pt, Pd, and Ag, the reflective layer 150 may be formed before the etching process of forming the isolation region S1.

Although not shown in the drawing, the base layer 103 or the substrate 101 may be exposed through a bottom surface of the isolation region S1 (refer to FIG. 2). Here, a horizontal width W1 and W3 of the isolation region S1 may be the same as a horizontal width W2 of each of the second conductivity type semiconductor layer 110p, the electrode layer 120, and the reflective layer 150. However, the inventive concept is not limited thereto, and the width W1 and W3 of the isolation region S1 may be less than or greater than the horizontal width W2 of each of the second conductivity type semiconductor layer 110p, the electrode layer 120, and the reflective layer 150.

In this way, by forming the reflective layer 150 first and then forming the isolation region S1, a horizontal width of the light emitting structure ES may be significantly reduced compared to a case in which the reflective layer 150 is formed after forming the isolation region S1.

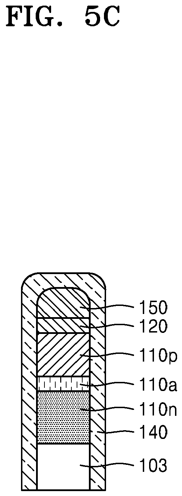

Referring to FIGS. 4 and 5C, after etching is completed, an insulating spacer 140 is conformally formed on side surfaces of the second conductivity type semiconductor layer 110p, the electrode layer 120, and the reflective layer 150 and a top surface of the reflective layer 150 in operation P130. The insulating spacer 140 may be formed by an atomic layer deposition (ALD) method to a thickness in a range of about 10 nm to about 1 µm.

Referring to FIGS. 4 and 5D, after forming the insulating spacer 140, a top surface of the insulating spacer 140 is etched so that the top surface of the reflective layer 150 is exposed in operation P140. While the top surface of the insulating spacer 140 is etched, the reflective layer 150 may serve as an etch stop layer. Due to the etching process, the vertical level of the uppermost surface 150T of the reflective layer 150 may be the same as the vertical level of the uppermost surface 140T of the insulating spacer 140. Due to the etching process on the top surface of the insulating spacer 140, a corner of the uppermost surface 140T of the insulating spacer 140 may be formed in a round shape. In addition, a part of the etched insulating spacer 140 may remain on a corner of the reflective layer 150. A part of the insulating spacer 140 on the reflective layer 150 may prevent the bonding pad 160 to be deposited later from being deposited on side surfaces of the reflective layer 150.

Referring to FIGS. 4 and 2, the bonding pad 160 is formed on the top surface of the reflective layer 150 in the result of FIG. 5D, in which the top surface of the insulating spacer 140 is etched, in operation P150. A horizontal width of the bonding pad 160 may be the same as the horizontal width of the reflective layer 150. The bonding pad 160 may be formed by one of an electroplating process and an electroless plating process. Accordingly, a corner Ebr of the uppermost surface 160T of the bonding pad 160 may be formed in a round shape.

As such, the reflective layer 150 may be formed of a material that does not affect the aqueous solution including one of TMAH, KOH, NaOH, NHOH, and NH₄OH and may be stacked before forming the isolation region S1. Accordingly, a margin area may be greatly reduced compared to a case in which the reflective layer 150 is deposited after forming the isolation region S1. By forming the isolation region S1 (refer to FIG. 5B) after stacking the reflective layer 150, the second conductivity type semiconductor layer 110p and the electrode layer 120 may be etched according to the width of the reflective layer 150. Accordingly, a minimum size of the semiconductor light emitting device 10 may be reduced.

Accordingly, the number of semiconductor light emitting devices 10 that may be produced by one substrate may be increased. That is, process cost of the semiconductor light emitting device 10 according to the inventive concept may be reduced.

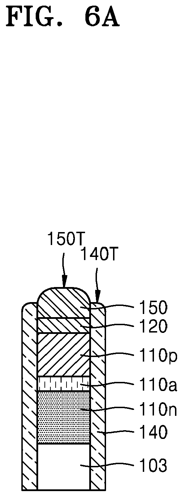

FIGS. 6A to 6C are cross-sectional views illustrating a method of manufacturing a semiconductor light emitting device including an oxide layer employable in the semiconductor light emitting device according to another embodiment. Here, the operations of FIGS. 5A to 5D may be performed in advance.

Referring to FIGS. 2 and 6A, the insulating spacer 140 is over-etched by the etching process performed in FIG. 5D. The vertical level of the uppermost surface 140T of the insulating spacer 140 may be closer to the first conductivity type semiconductor layer 110n (refer to FIG. 2) than the vertical level of the uppermost surface 150T of the reflective layer 150. The insulating spacer 140 may not cover a part of the side wall of the reflective layer 150.

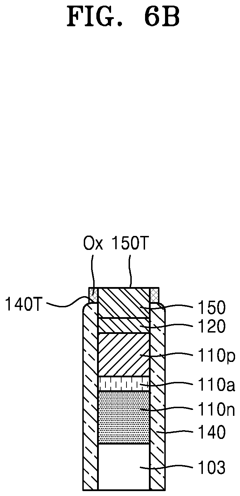

Referring to FIG. 6B, an oxide layer Ox may be formed on the side wall of the reflective layer 150, which is not covered with the insulating spacer 140. The oxide layer Ox may be formed by an oxygen (O₂) plasma process. The oxide layer Ox may contact the uppermost surface 140T of the insulating spacer 140. The oxide layer Ox may vertically overlap the insulating spacer 140. The oxide layer Ox may interfere with the electroplating process or the electroless plating process of the bonding pad 160. That is, the bonding pad 160 may not be formed on the oxide layer Ox. Accordingly, a surface of the reflective layer 150, which is covered with the oxide layer Ox, may not be covered with the bonding pad 160.

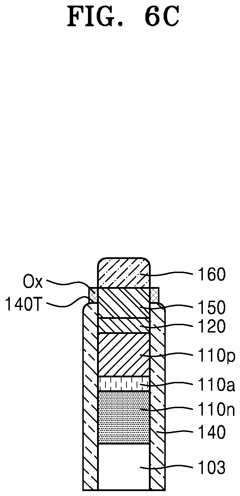

Referring to FIG. 6C, after the oxide layer Ox is formed, the bonding pad 160 may be formed on the reflective layer 150. It is possible to prevent the bonding pad 160 from being deposited on the side wall of the reflective layer 150 by the plating process due to plating interference of the oxide layer Ox. It is possible to improve the stability of the semiconductor light emitting device by covering the side wall of the reflective layer 150 with the oxide layer Ox.

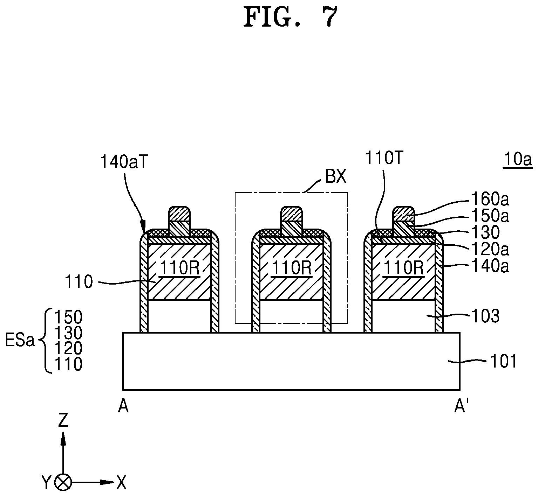

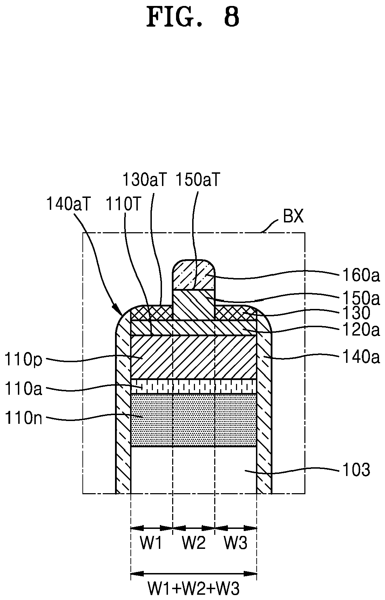

FIG. 7 is a cross-sectional view illustrating a semiconductor light emitting device 10a according to another embodiment. FIG. 8 is an enlarged cross-sectional view of a partial region indicated by "BX" in FIG. 7. Description previously given with reference to FIGS. 1 to 3 is simply given or omitted.

Referring to FIGS. 7 and 8, a light emitting structure ESa may be used instead of the light emitting structure ES illustrated in FIG. 2. The semiconductor light emitting device 10a may include a first conductivity type semiconductor layer 110n, a second conductivity type semiconductor layer 110p, an insulating spacer 140a, an electrode layer 120a, a plurality of reflective layers 150a, a plurality of bonding pads 160a, and an insulating layer 130 that are formed on a substrate 101. Here, the light emitting structure ESa may include the second conductivity type semiconductor layer 110p, the electrode layer 120a, the insulating layer 130, the reflective layer 150a, and the bonding pad 160a.

A horizontal width of the reflective layer 150a may be the same as a horizontal width of the bonding pad 160a. The horizontal width of each of the reflective layer 150a and the bonding pad 160a may be a second width W2. A horizontal width of the second conductivity type semiconductor layer 110p may be the same as a horizontal width of the electrode layer 120a. The horizontal width of each of the second conductivity type semiconductor layer 110p and the electrode layer 120a may be obtained by summing first to third widths W1 to W3. Here, a sum of the first to third widths W1 to W3 may be three times the second width W2. Each of the reflective layer 150a and the bonding pad 160a may not vertically overlap the insulating layer 130.

The reflective layer 150a may be formed on a part of a top surface of the electrode layer 120a. The insulating layer 130 may be formed on another part of the top surface of the electrode layer 120a. The reflective layer 150a may pass through the insulating layer 130. In embodiments, a vertical level of the uppermost surface 150aT of the reflective layer 150a may be farther from the second conductivity type semiconductor layer 110p than a vertical level of the uppermost surface 130aT of the insulating layer 130. In addition, the insulating layer 130 may cover a part of a side wall of the reflective layer 150a. In embodiments, a vertical level of the uppermost surface 140aT of the insulating spacer 140a may be farther from the first conductivity type semiconductor layer 110n than a vertical level of the top surface 110T of the light emitting structure 110R of the second conductivity type semiconductor layer 110p. In embodiments, the vertical level of the uppermost surface 140aT of the insulating spacer 140a may be farther from the first conductivity type semiconductor layer 110n than a vertical level of the electrode layer 120a.

Although not shown in the drawings, an oxide layer (not shown) may be formed on the side wall of the reflective layer 150a, which is not covered with the insulating layer 130. The oxide layer may be formed in the same manner as the oxide layer Ox of FIGS. 6B and 6C. The oxide layer may prevent the bonding pad 160a from being deposited on the side wall of the reflective layer 150a.

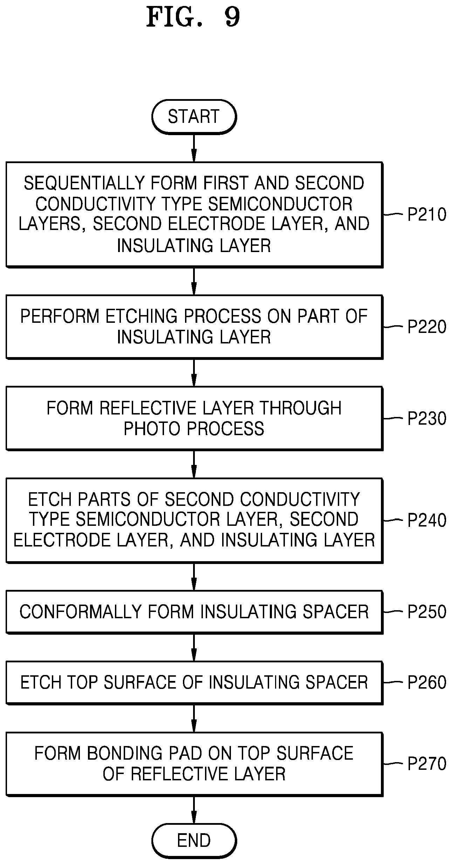

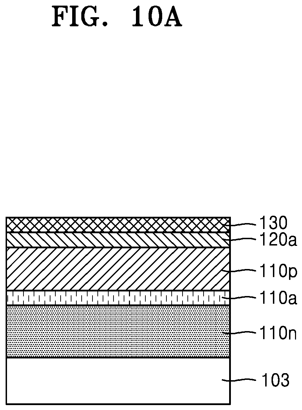

FIG. 9 is a flowchart illustrating a method of manufacturing a semiconductor light emitting device, according to another embodiment. FIGS. 10A to 10F are cross-sectional views illustrating a method of manufacturing a semiconductor light emitting device, according to another embodiment in a process order. Here, description previously given with reference to FIGS. 2 and 3 is simply given or omitted.

Referring to FIGS. 9 and 10A, the first conductivity type semiconductor layer 110n, the active layer 110a, the second conductivity type semiconductor layer 110p, the electrode layer 120a, and the insulating layer 130 are sequentially formed in operation P210. Before operation P210, the operation of sequentially forming the base layer 103, the first conductivity type semiconductor layer 110n, and the active layer 110a on the substrate 101 may be performed.

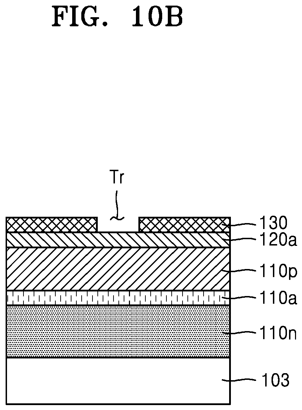

Referring to FIGS. 9 and 10B, an etching process is performed on a part of the insulating layer 130 in operation P220. Here, a part of the insulating layer 130 may be etched to form a trench Tr. The electrode layer 120a may be exposed through a bottom surface of the trench Tr. While etching the insulating layer 130, the electrode layer 120a may serve as an etch stop layer.

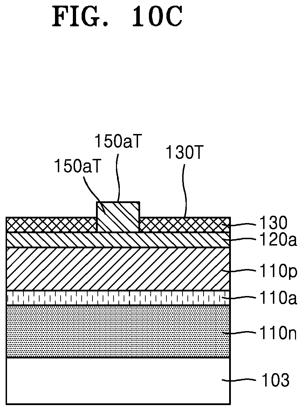

Referring to FIGS. 9 and 10C, the reflective layer 150a may be formed by a photo process. The reflective layer 150a may be formed in the trench Tr formed by the etching process. The vertical level of the uppermost surface 150aT of the reflective layer 150a may be farther from the electrode layer 120a than a vertical level of the uppermost surface 130T of the insulating layer 130.

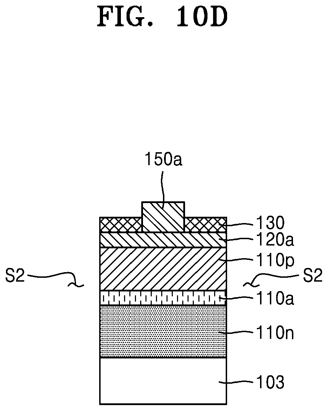

Referring to FIGS. 9 and 10D, after forming the reflective layer 150a, parts of the second conductivity type semiconductor layer 110p, the electrode layer 120a, and the insulating layer 130 may be etched in operation P240. The first conductivity type semiconductor layer 110n, the active layer 110a, the second conductivity type semiconductor layer 110p, the electrode layer 120a, and the insulating layer 130 may be etched to form an isolation region S2. Each two of the plurality of light emitting structures ESa may be apart from each other in the horizontal direction with the isolation region S2 therebetween (refer to FIG. 7). A horizontal width of a light emitting structure 110Ra of the second conductivity type semiconductor layer 110p defined by the isolation region S2 may be greater than a horizontal width of one of the plurality of light emitting structures 110R of the second conductivity type semiconductor layer 110p of FIG. 2.

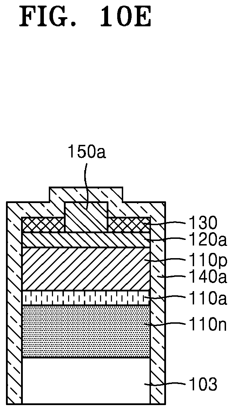

Referring to FIGS. 9 and 10E, after etching the parts of the second conductivity type semiconductor layer 110p, the electrode layer 120a, and the insulating layer 130, the insulating spacer 140a is conformally formed in operation P250. Specifically, the insulating spacer 140a may be conformally formed along the side wall of the base layer 103, the first conductivity type semiconductor layer 110n, the active layer 110a, the second conductivity type semiconductor layer 110p, the electrode layer 120a, a side wall of the insulating layer 130, a top surface of the insulating layer 130, and the side wall and a top surface of the reflective layer 150a. The insulating spacer 140a may be formed in the same manner as the deposition method of operation P130 described above.

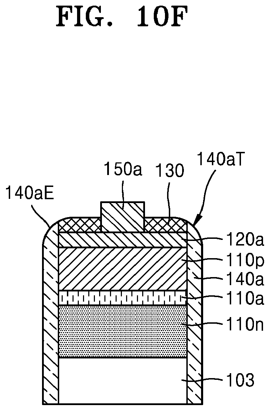

Referring to FIGS. 9 and 10F, after the insulating spacer 140a is formed, a top surface of the insulating spacer 140a may be etched in operation P260. At this time, the etching process may be performed by using the aqueous solution including one of TMAH, KOH, NaOH, and NH₄OH. Although the insulating spacer 140a is etched, the reflective layer 150a may not be etched because the reflective layer 150a includes a material that is not affected by the aqueous solution including one of TMAH, KOH, NaOH, and NH₄OH. By etching the insulating spacer 140a, the uppermost surface 150aT of the reflective layer 150a may be exposed. In addition, by etching the insulating spacer 140a, a corner 140aE of the uppermost surface 140aT of the insulating spacer 140a may be formed in a round shape.

Referring to FIGS. 8 and 9, in the result of FIG. 10F in which the top surface of the insulating spacer 140a is etched, the bonding pad 160a may be formed to contact the uppermost surface 150aT of the reflective layer 150a in operation P270. The bonding pad 160a may be formed by one of an electroplating process and an electroless plating process. In the drawings, the bonding pad 160a is illustrated in a rectangular shape, but may have a shell shape of which the uppermost surface has a round corner.

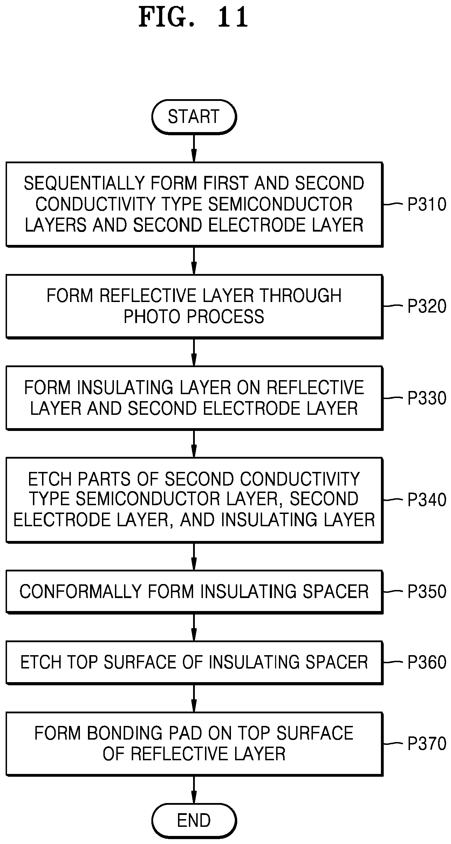

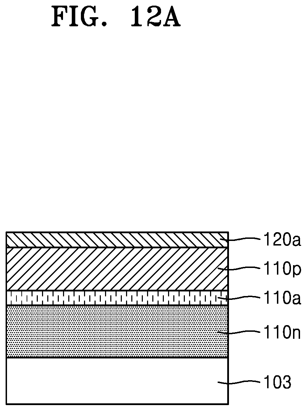

FIG. 11 is a flowchart illustrating a method of manufacturing a semiconductor light emitting device, according to another embodiment. FIGS. 12A to 12E are cross-sectional views illustrating a method of manufacturing a semiconductor light emitting device, according to another embodiment in a process order. Hereinafter, description previously given with reference to FIGS. 4 and 9 is omitted.

Referring to FIGS. 11 and 12A, the first conductivity type semiconductor layer 110n, the active layer 110a, the second conductivity type semiconductor layer 110p, and the electrode layer 120a are sequentially formed in operation P310.

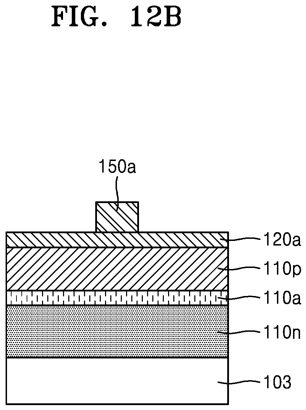

Referring to FIGS. 11 and 12B, next, the reflective layer 150a is formed on a part of the electrode layer 120a in operation P320.

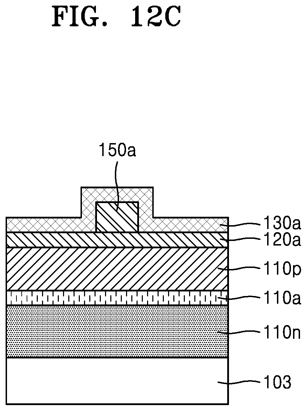

Referring to FIGS. 11 and 12C, after forming the reflective layer 150a, the insulating layer 130a is formed on the reflective layer 150a and the electrode layer 120a in operation P330.

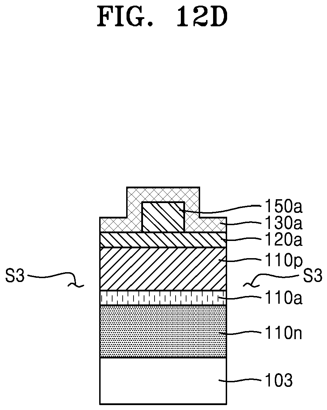

Referring to FIGS. 11 and 12D, parts of the first conductivity type semiconductor layer 110n, the active layer 110a, the second conductivity type semiconductor layer 110p, the electrode layer 120a, and the insulating layer 130a are etched in operation P340. An isolation region S3 may be formed by etching the parts of the first conductivity type semiconductor layer 110n, the active layer 1 10a, the second conductivity type semiconductor layer 110p, the electrode layer 120a, and the insulating layer 130a. The light emitting structure 110Ra of the second conductivity type semiconductor layer 110p defined by the isolation region S3 may be the same as the light emitting structure formed in operation P240.

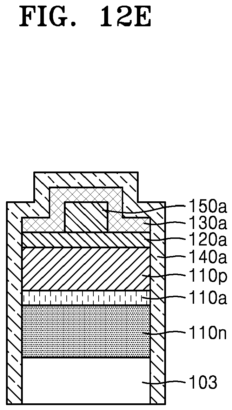

Referring to FIGS. 11 and 12E, after etching the parts of the first conductivity type semiconductor layer 110n, the active layer 110a, the second conductivity type semiconductor layer 110p, the electrode layer 120a, and the insulating layer 130, the insulating spacer 140a is conformally formed in operation P350.

For the result of FIG. 12E, the top surface of the insulating spacer 140a is etched in operation P360, and the bonding pad 160a is formed on the top surface of the reflective layer 150a in operation P370. Accordingly, a semiconductor light emitting device may be formed in the same manner as illustrated in FIG. 8. Because operations P350, P360, and P370 are respectively the same as operations P250, P260, and P270, detailed description thereof is omitted.

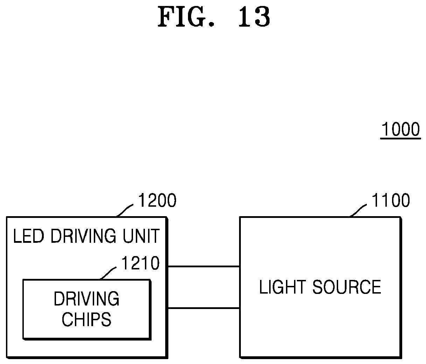

FIG. 13 is a block diagram illustrating a configuration of a light source module 1000 according to another embodiment.

Referring to FIG. 13, the light source module 1000 may include a light source 1100 and a light emitting diode (LED) driver 1200.

The light source 1100 may include an LED array. In embodiments, the LED array constituting the light source 1100 may include a plurality of pixels PX including a plurality of light emitting cells CL The plurality of pixels PX included in the LED array may include the plurality of light emitting cells CL supported by a support structure, for example, a light emitting structure ES illustrated in FIG. 2

The LED array may include a plurality of sub-arrays Light-emitting cells CL included in different sub-arrays SA among the plurality of sub-arrays SA may be electrically separated from each other.

The LED driver 1200 may be connected to a power supply, and the power supply may generate an input voltage required for the light source 1100 to operate and provide the generated input voltage to the light source 1100. In embodiments, when the light source module 1000 includes a head lamp for a vehicle, the power supply may include a battery mounted in the vehicle. In embodiments, when the light source module 1000 includes a lighting fixture for home or business use, the light source module 1000 may further include an alternating current (AC) power source for generating an AC voltage, a rectifier circuit for rectifying the AC voltage to generate a direct current (DC) voltage, and a voltage regulator circuit.

The LED driver 1200 may include a plurality of driving chips 1210. Each of the plurality of driving chips 1210 may include an integrated circuit chip. The plurality of driving chips 1210 may drive the LED array included in the light source 1100. In embodiments, the plurality of driving chips 1210 may be electrically connected to at least one corresponding sub-array of the plurality of sub-arrays SA and may control the plurality of light emitting cells CL included in the corresponding sub-array SA to operate. The number of driving chips 1210 may be the same as or different from the number of sub-arrays SA included in the light source 1100. In embodiments, the plurality of driving chips 1210 may be mounted on a printed circuit board (PCB).

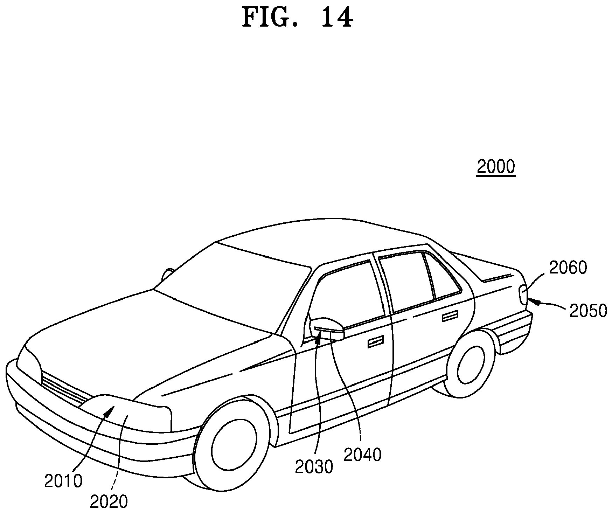

FIG. 14 is a perspective view schematically illustrating a lighting device including a light source module according to embodiments.

Referring to FIG. 14, a head lamp module 2020 may be provided in a head lamp 2010 of a vehicle, a side mirror lamp module 2040 may be provided in an external side mirror 2030, and a tail lamp module 2060 may be provided in a tail lamp 2050. At least one of the head lamp module 2020, the side mirror lamp module 2040, and the tail lamp module 2060 may include at least one of the light source modules according to embodiments.

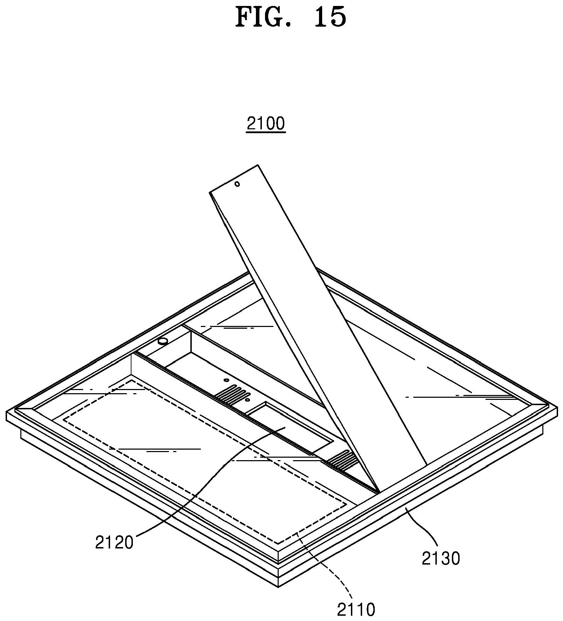

FIG. 15 is a perspective view schematically illustrating a flat panel lighting device 2100 including a light source module 2110 according to embodiments.

Referring to FIG. 15, the flat panel lighting device 2100 may include a light source module 2110, a power supply 2120, and a housing 2130.

The light source module 2110 may include at least one of the light source modules according to embodiments. The light source module 2110 may form a flat surface as a whole.

The power supply 2120 may supply power to the light source module 2110. The housing 2130 may have an accommodation space so that the light source module 2110 and the power supply 2120 are accommodated therein, and has a hexahedral shape open on one side. The light source module 2110 may be arranged to emit light to an open side surface of the housing 2130.

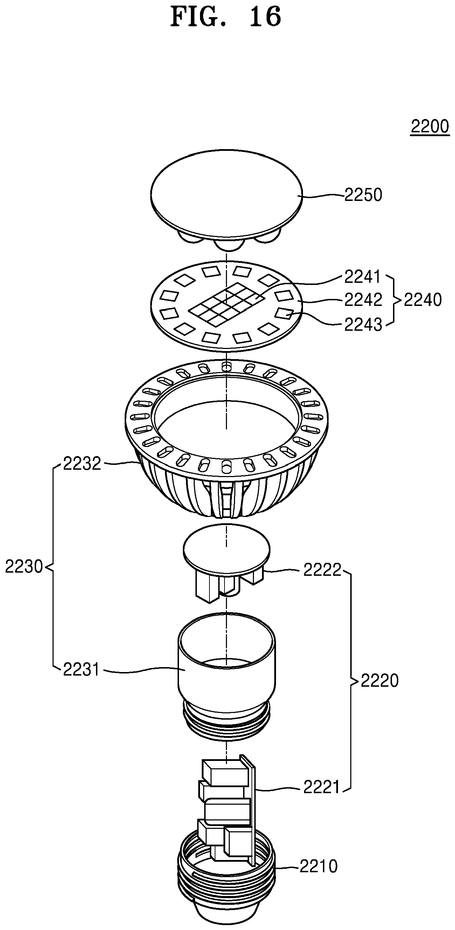

FIG. 16 is an exploded perspective view schematically illustrating a lighting device 2200 including a light source module 2240 according to embodiments.

The lighting device 2200 may include a socket 2210, a power supply 2220, a heat dissipation unit 2230, the light source module 2240, and an optical unit 2250.

The socket 2210 may be configured to be replaceable with an existing lighting device. Power supplied to the lighting device 2200 may be applied through the socket 2210. The power supply 2220 may be divided into a first power supply 2221 and a second power supply 2222 to be assembled. The heat dissipation unit 2230 may include an internal heat dissipation unit 2231 and an external heat dissipation unit 2232. The internal heat dissipation unit 2231 may be directly connected to the light source module 2240 and/or the power supply 2220 so that heat may be transferred to the external heat dissipation unit 2232. The optical unit 2250 may include an internal optical unit (not shown) and an external optical unit (not shown and may be configured to evenly disperse light emitted by the light source module 2240.

The light source module 2240 may receive power from the power supply 2220 and may emit light to the optical unit 2250. The light source module 2240 may include one or more light emitting device packages 2241, a circuit board 2242, and controllers 2243. The controllers 2243 may store driving information of the light emitting device packages 2241. The light source module 2240 may include at least one of the light source modules according to embodiments.

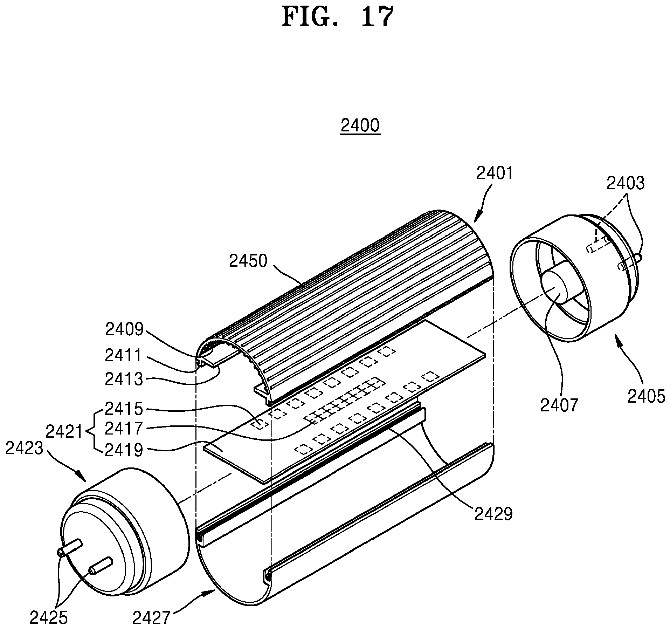

FIG. 17 is an exploded perspective view schematically illustrating a bar type lighting device 2400 including a light source module 2421 according to embodiments.

Referring to FIG. 17, the bar type lighting device 2400 includes a heat dissipation member 2401, a cover 2427, a light source module 2421, a first socket 2405, and a second socket 2423. A plurality of heat dissipation fins 2450 and 2409 may be formed in a concavo-convex shape on an internal and/or external surface of the heat dissipation member 2401, and the plurality of heat dissipation fins 2450 and 2409 may be designed to have various shapes and intervals. Protruding supports 2413 are formed in the heat dissipation member 2401. The light source module 2421 may be fixed to the protruding supports 2413. Locking jaws 2411 may be formed at both ends of the heat dissipation member 2401.

Locking grooves 2429 are formed in the cover 2427, and the locking jaws 2411 of the heat dissipation member 2401 may be respectively coupled to the locking grooves 2429 in a hook coupling structure. Positions at which the locking grooves 2429 and the locking jaws 2411 are formed may be interchanged with each other.

The light source module 2421 may include a PCB 2419, a light source 2417, and a controller 2415. The controller 2415 may store driving information of the light source 2417. Circuit wires for operating the light source 2417 are formed on the PCB 2419. In addition, components for operating the light source 2417 may be included.

The light source module 2421 may include at least one of the light source modules according to embodiments.

The first and second sockets 2405 and 2423 as a pair of sockets are coupled to both ends of a cylindrical cover unit including the heat dissipation member 2401 and the cover 2427. For example, the first socket 2405 may include electrode terminals 2403 and a power supply 2407, and dummy terminals 2425 may be arranged in the second socket 2423. In addition, an optical sensor and/or a communication module may be embedded in either the first socket 2405 or the second socket 2423.

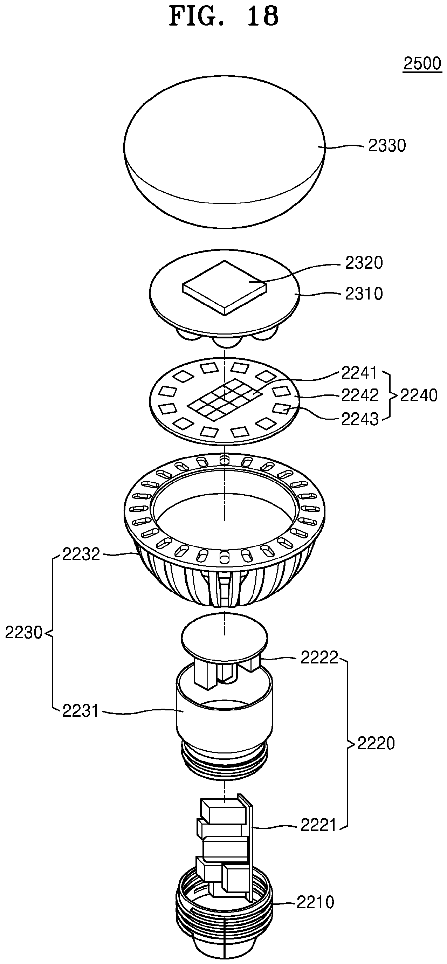

FIG. 18 is an exploded perspective view schematically illustrating a lighting device 2500 including a light source module 2240 according to embodiments.

The lighting device 2500 illustrated in FIG. 18 is similar to the lighting device 2200 illustrated in FIG. 16. The lighting device 2500 includes a reflector 2310 and a communication module 2320 arranged on the light source module 2240. The reflector 2310 may reduce glare by evenly spreading light from a light source to a side and back. The communication module 2320 may be mounted on the reflector 2310. Home-network communication may be implemented through the communication module 2320. For example, the communication module 2320 may include a wireless communication module using Zigbee, WiFi, or LiFi, and may control lighting devices installed inside and outside the home, such as turning on/off and adjusting brightness of the lighting devices, or may control electronic products and automobile systems inside and outside the home, such as a TV, a refrigerator, an air conditioner, a door lock, and an automobile through a smartphone or a wireless controller. The reflector 2310 and the communication module 2320 may be covered with a cover 2330.

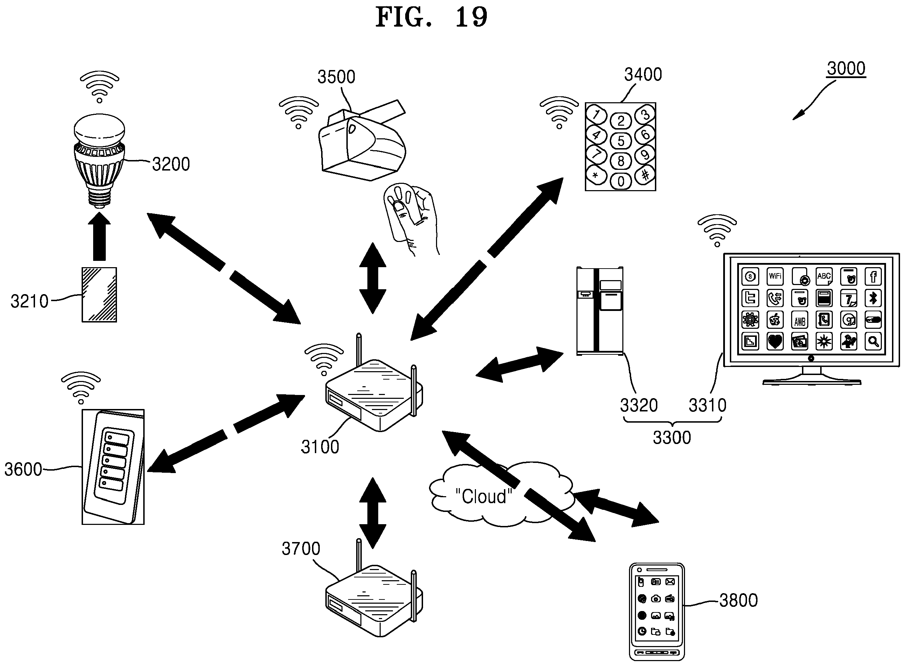

FIG. 19 is a schematic diagram illustrating an indoor lighting control network system 3000 including a light source module according to embodiments.

Referring to FIG. 19, the indoor lighting control network system 3000 may include a complex smart lighting-network system, in which lighting technology using light emitting devices such as light emitting diodes (LED), Internet of Things (IoT) technology, and wireless communication technology are converged. The indoor lighting control network system 3000 may be implemented using various lighting devices and wired/wireless communication devices, or may be implemented based on an IoT environment to collect/process various information items and provide the information items to users.

An LED lamp 3200 included in the indoor lighting control network system 3000 may check and control operating states of a plurality of devices 3300, 3400, 3500, 3600, 3700, and 3800 included in the IoT environment based on functions such as visible light communication of the LED lamp 3200 as well as may receive information on a surrounding environment from a gateway 3100 to control lighting of the LED lamp 3200.

The LED lamp 3200 may include at least one of the light source modules according to embodiments. The LED lamp 3200 may be communicatively connected to the gateway 3100 by a wireless communication protocol such as WiFi, Zigbee, or LiFi and may have at least one lamp communication module 3210 for this purpose.

When the indoor lighting control network system 3000 is applied to a home, the plurality of devices 3300, 3400, 3500, 3600, 3700, and 3800 may include a home appliance 3300, a digital door lock 3400, a garage door lock 3500, a lighting switch 3600 installed on a wall, a router 3700 for wireless communication network relay, and a mobile device 3800 such as a smartphone, a tablet, or a laptop computer.

In the indoor lighting control network system 3000, the LED lamp 3200 may check the operating states of the plurality of devices 3300, 3400, 3500, 3600, 3700, and 3800 using a wireless communication network (Zigbee, WiFi, or LiFi) installed in the home, or may automatically adjust illumination of the LED lamp 3200 according to a surrounding environment/situation. In addition, the plurality of devices 3300, 3400, 3500, 3600, 3700, and 3800 included in the indoor lighting control network system 3000 may be controlled by using LiFi communication using visible light emitted by the LED lamp 3200.

The LED lamp 3200 may automatically adjust the illumination of the LED lamp 3200 based on the surrounding environment information transmitted from the gateway 3100 through the lamp communication module 3210 or surrounding environment information collected from a sensor mounted on the LED lamp 3200. For example, the lighting brightness of the LED lamp 3200 may be automatically adjusted according to the type of program broadcast on a television 3310 or brightness of a screen. To this end, the LED lamp 3200 may receive operation information of the television 3310 from the lamp communication module 3210 connected to the gateway 3100. The lamp communication module 3210 may be integrally modularized with a sensor and/or a controller included in the LED lamp 3200.

For example, when a predetermined time elapses after the digital door lock 3400 is locked without a person in the home, the LED lamp 3200, which is turned on, may be turned off to prevent waste of electricity. Alternatively, in a case in which a security mode is set through the mobile device 3800, when the digital door lock 3400 is locked without someone at home, the LED lamp 3200 may be kept turned on.

An operation of the LED lamp 3200 may be controlled according to the surrounding environment information collected through various sensors connected to the indoor lighting control network system 3000. For example, when the indoor lighting control network system 3000 is implemented in a building, by combining lighting, location sensors, and communication modules in the building, and collecting location information of people in the building, the lighting may be turned on or off, or the collected information may be displayed in real time to enable facility management and efficient use of idle spaces.

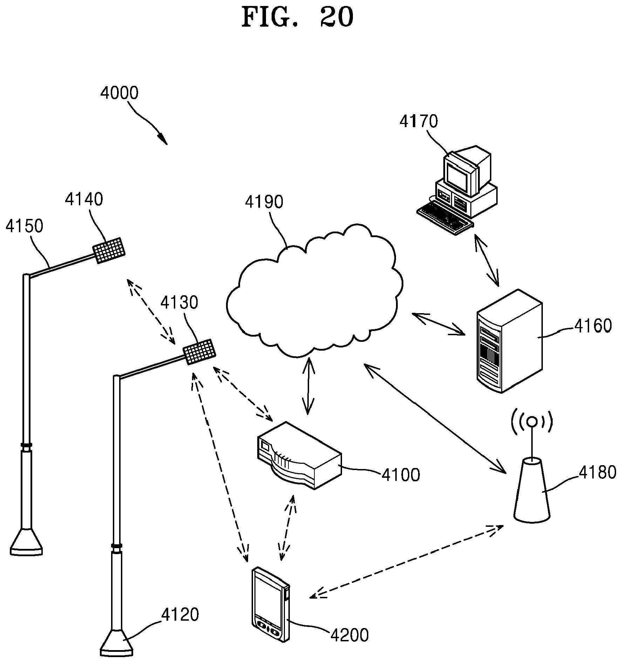

FIG. 20 is a schematic diagram illustrating a network system 4000 including a light source module according to embodiments. FIG. 20 illustrates a schematic configuration of the network system 4000 applied to an open space.

Referring to FIG. 20, the network system 4000 may include a communication connection device 4100, a plurality of lighting fixtures 4120 and 4150 installed at predetermined intervals and communicatively connected to the communication connection device 4100, a server 4160, a computer 4170 for managing the server 4160, a communication base station 4180, a communication network 4190 connecting communication devices, and a mobile device 4200.

Each of the plurality of lighting fixtures 4120 and 4150 installed in an open outdoor space such as a street or a park may include smart engines 4130 and 4140. The smart engines 4130 and 4140 may include a sensor for collecting the surrounding environment information and a communication module as well as a light emitting device for emitting light and a driver for driving the light emitting device.

The smart engines 4130 and 4140 may include at least one of the light source modules according to embodiments.

With the communication module, the smart engines 4130 and 4140 may communicate with other surrounding devices according to a communication protocol such as WiFi, Zigbee, or LiFi. The smart engine 4130 may be communicatively connected to the smart engine 4140, and WiFi expansion technology (WiFi Mesh) may be applied to communication between the smart engines 4130 and 4140. At least one smart engine 4130 may be connected to the communication connection device 4100 connected to the communication network 4190 through wired/wireless communication.

The communication connection device 4100 is an access point (AP) capable of performing wired/wireless communication, and may mediate communication between the communication network 4190 and other equipment. The communication connection device 4100 may be connected to the communication network 4190 by at least one of wired/wireless methods and may be mechanically accommodated in any one of the plurality of lighting fixtures 4120 and 4150, for example.

The communication connection device 4100 may be connected to the mobile device 4200 through a communication protocol such as WiFi. A user of the mobile device 4200 may receive the surrounding environment information collected by the plurality of smart engines 4130 and 4140, for example, surrounding traffic information and weather information through the communication connection device 4100 connected to the smart engine 4130 of the neighboring lighting fixture 4120. The mobile device 4200 may be connected to the communication network 4190 through the communication base station 4180 by a wireless cellular communication method such as 3G or 4G.

The server 4160 connected to the communication network 4190 may receive the information collected by the smart engines 4130 and 4140 mounted on each of the plurality of lighting fixtures 4120 and 4150 and may monitor the operating states of the plurality of lighting fixtures 4120 and 4150. The server 4160 may be connected to the computer 4170 providing a management system, and the computer 4170 may execute software that may monitor and manage the operating states of the smart engines 4130 and 4140.

While the inventive concept has been particularly shown and described with reference to embodiments thereof, it will be understood that various changes in form and details may be made therein without departing from the spirit and scope of the following claims.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the spirit and scope of the present invention as set forth in the following claims.

## Claims

1. A semiconductor light emitting device comprising:
a first conductivity type semiconductor layer arranged on a substrate;
a second conductivity type semiconductor layer arranged on the first conductivity type semiconductor layer;
an active layer between the first conductivity type semiconductor layer and the second conductivity type semiconductor layer;
an electrode layer formed on a top surface of the second conductivity type semiconductor layer;
a reflective layer formed on a part of a top surface of the electrode layer;
a bonding pad formed on a top surface of the reflective layer;
an insulating layer formed on another part of the top surface of the electrode layer; and
an insulating spacer conformally formed along side walls of the first conductivity type semiconductor layer, the second conductivity type semiconductor layer, and the active layer, and covering a part of the side wall of the insulating layer,
wherein the reflective layer includes a material that is not etched by an aqueous solution including one of tetramethyl ammonium hydroxide (TMAH), KOH, NaOH, and NH4OH, and
wherein the bonding pad has a shell shape including a part of which the width gradually decreases as the part distances from the reflective layer.

2. The semiconductor light emitting device as claimed in claim 1, wherein the reflective layer includes one of chrome (Cr), nickel (Ni), and a noble metal material, and
wherein the noble metal material includes at least one of gold (Au), platinum (Pt), palladium (Pd), and silver (Ag).

3. The semiconductor light emitting device as claimed in claim 1 or 2, wherein a corner of a top surface of the bonding pad has a round shape.

4. The semiconductor light emitting device as claimed in any one of claims 1 to 3, wherein the insulating spacer has a constant thickness along the side walls of the first conductivity type semiconductor layer, the second conductivity type semiconductor layer, and the active layer.

5. The semiconductor light emitting device as claimed in any one of claims 1 to 4, further comprising an oxide layer contacting a side wall of the reflective layer,
wherein the oxide layer does not horizontally overlap the insulating spacer.

6. The semiconductor light emitting device as claimed in any one of claims to 1 to 4, wherein the top surface of the reflective layer contacts a top surface of the bonding pad, and
wherein a corner of the reflective layer has a round shape.

7. The semiconductor light emitting device as claimed in any one of claims 1 to 5, wherein a vertical level of an uppermost surface of the reflective layer is farther from the second conductivity type semiconductor layer than a vertical level of the uppermost surface of an insulating spacer or the same as the vertical level of an uppermost surface of the insulating spacer.

8. The semiconductor light emitting device as claimed in any one of claims 1 to 7, wherein each of horizontal widths of the first conductivity type semiconductor layer, the second conductivity type semiconductor layer, and the active layer are greater than a horizontal width of the reflective layer.

9. The semiconductor light emitting device as claimed in any one of claims 1 to 8, comprising:
a plurality of first conductivity type semiconductor layers arranged on the substrate;
a plurality of second conductivity type semiconductor layers formed on the plurality of first conductivity type semiconductor layers;
a plurality of active layers between the plurality of first conductivity type semiconductor layers and the plurality of second conductivity type semiconductor layers;
a plurality of electrode layers formed on top surfaces of the plurality of second conductivity type semiconductor layers;
a plurality of reflective layers formed on parts of top surfaces of the plurality of electrode layers;
a plurality of bonding pads formed on top surfaces of the plurality of reflective layers;
an insulating layer formed on other parts of the top surfaces of the plurality of electrode layers;
an insulating spacer conformally formed along side walls of the plurality of first conductivity type semiconductor layers, the plurality of second conductivity type semiconductor layers, and the plurality of active layers, and covering a part of a side wall of the insulating layer; and
an oxide layer contacting a side wall of each of the plurality of reflective layers,
wherein the oxide layer does not horizontally overlap the insulating spacer,
wherein the plurality of reflective layers includes a material that is not etched by an aqueous solution including one of tetramethyl ammonium hydroxide (TMAH), KOH, NaOH, and NH4OH, and the plurality of reflective layers include one of chrome (Cr), nickel (Ni), and a noble metal material, and
wherein each of the plurality of bonding pads has a shell shape including a part of which the width gradually decreases as the part distances from each of the plurality of reflective layers.

10. The semiconductor light emitting device as claimed in claim 9,
wherein the plurality of electrode layers and the plurality of second conductivity type semiconductor layers are arranged in a region limited by the insulating spacer.

11. The semiconductor light emitting device as claimed in claim 9 or 10, wherein a corner of an uppermost surface of each of the plurality of reflective layers has a round shape, and
wherein the round corner is covered with the insulating spacer.

12. The semiconductor light emitting device as claimed in any one of claims 9 to 11, wherein each of the plurality of reflective layers and the plurality of bonding pads does not vertically overlap the insulating layer.

13. The semiconductor light emitting device as claimed in any one of claims 9 to 12, wherein a vertical level of an uppermost surface of the insulating spacer is farther from the substrate than a vertical level of a top surface of each of the plurality of electrode layers, and
wherein a vertical level of the uppermost surface of the insulating spacer is closer from the substrate than a vertical level of a top surface of the insulating layer.

14. The semiconductor light emitting device as claimed in claims 1 to 13, wherein:
each first conductivity type semiconductor layer is an n-type gallium nitride, GaN, layer; and
each second conductivity type semiconductor layer is a p-type GaN layer.

15. The semiconductor light emitting device as claimed in claim 14, wherein a corner of the uppermost surface of each reflective layer has a round shape, and
wherein the corners of each reflective layer is covered with the insulating spacer and is apart from each bonding pad.
